# EUROPEAN PATENT SPECIFICATION

(11) **EP 4 616 466 B1**
(45) Date of publication and mention of the grant of the patent: **24.06.2026**
(21) Application number: 23800818.9
(22) Date of filing: 02.11.2023
(51) Int. Cl.: H01M 10/42, H01M 50/213, H01M 50/519, H05K 1/18, H05K 7/14

(54) **BATTERY COMPARTMENT ASSEMBLIES FOR PATIENT MONITORS**
BATTERIEFACHANORDNUNGEN FÜR PATIENTENMONITORE
ENSEMBLES COMPARTIMENTS DE BATTERIE POUR MONITEURS DE PATIENT

(30) Priority: 09.11.2022 US 202263423908 P
(43) Date of publication of application: 17.09.2025
(73) Proprietor: Koninklijke Philips N.V., 5656 AE Eindhoven (NL)
(72) Inventor: MAKIE, Francis, 5656 AG Eindhoven (NL)
(74) Representative: Philips Intellectual Property & Standards
(86) International application number: PCT/EP2023/080562
(87) International publication number: WO 2024/099871

(56) References cited:
- EP-B1- 2 668 682
- JP-A- H0 997 599
- US-A- 5 250 371
- US-B1- 6 733 919
- US-B2- 11 134 565
- US-B2- 8 273 471

## Description

### Field of the Disclosure

The present disclosure relates generally to battery compartment assemblies having a flexible circuit spring component, and more specifically to patient monitors including battery compartment assemblies with features extending the life cycle thereof.

### Background

Removable batteries are used in numerous electronic devices. A battery compartment or adapter is often provided as an interface between one or more batteries and the electronic device that the one or more batteries power. To make electrical contact with the batteries, known battery compartments provide metal spring contacts for interfacing with the batteries. Metal spring contacts can provide long-lasting electrical connected with the batteries over numerous cycles of removing and replacing the batteries. However, in medical applications, there are a number of drawbacks to using metal spring contacts. For example, metal spring contacts are bulky and add unnecessary expense, can entrap debris and be difficult to sterilize, have exposed areas that increase the likelihood of electrical shocks, and could cause failures in sensitive electronic components such as patient monitors, respirators, and the like. EP2668682B1 provides a battery adapter and method of making the same.

### Summary of the Disclosure

According to an embodiment of the present disclosure, a battery compartment assembly is provided. The battery compartment assembly comprises: a compartment casing having one or more sidewalls that define a receiving area sized to receive one or more removable batteries; a flexible circuit disposed within the receiving area of the compartment casing and having a folded portion that is folded over at least a first sidewall of the compartment casing, wherein the flexible circuit further comprises one or more conductive pads disposed in the folded portion of the flexible circuit; and a resilient spring member disposed between the first sidewall of the compartment casing and a first surface of the flexible circuit, the resilient spring member comprising one or more hollow cavities adjacent to each of the one or more conductive pads of the flexible circuit, wherein each hollow cavity is defined between the resilient spring member and the first sidewall of the compartment casing.

In an aspect, the resilient spring member comprises one or more solid portions between each of the one or more hollow cavities of the resilient spring member.

In an aspect, the resilient spring member comprises a sealing bead circumscribing one or more of the hollow cavities of the resilient spring member, the sealing bead being configured to provide a continuous contact with an exterior surface of the first sidewall of the compartment casing.

In an aspect, the sealing bead, the resilient spring member, and the first sidewall of the compartment casing forms an air chamber adjacent to one or more conductive pads of the flexible circuit.

In an aspect, the resilient spring member comprises a recess adjacent to at least one conductive pad of the flexible circuit, where the recess is defined between the resilient spring member and the folded portion of the flexible circuit.

In an aspect, the battery compartment assembly further comprises one or more stiffening members coupled to the flexible circuit adjacent to each of the one or more conductive pads, wherein the recess of the resilient spring member is sized to receive the one or more stiffening members.

In an aspect, the compartment casing includes one or more hollow cavities in the first sidewall of the compartment casing, each hollow cavity in the first sidewall of the compartment casing being defined between the first sidewall and the resilient spring member, and wherein each cavity in the first sidewall of the compartment casing is adjacent to a hollow cavity of the resilient spring member.

In an aspect, each of the hollow cavities of the compartment casing and each of the hollow cavities of the resilient spring member have a concave surface defining the hollow cavity.

In an aspect, the resilient spring member is secured between the first sidewall of the compartment casing and the folded portion of the flexible circuit by a bumper member.

In an aspect, the bumper member comprises one or more latches configured to join the bumper member to the resilient spring member and the compartment casing.

In an aspect, the compartment casing is formed from a rigid material.

In an aspect, the resilient spring member is formed from at least a compressible polymer.

According to another embodiment of the present disclosure, a worn patient monitor is provided. The worn patient monitor comprises a battery compartment assembly that provides one or more power contacts configured to power the worn patient monitor using one or more removable batteries. In an aspect, the battery compartment assembly comprises: a compartment casing having one or more sidewalls that define a receiving area sized to receive the one or more removable batteries; a flexible circuit disposed within the receiving area of the compartment casing and having a folded portion that is folded over at least a first sidewall of the compartment casing, wherein the flexible circuit further comprises one or more conductive pads disposed in the folded portion of the flexible circuit; and a resilient spring member disposed between the first sidewall of the compartment casing and a first surface of the flexible circuit, the resilient spring member comprising one or more hollow cavities adjacent to each of the one or more conductive pads of the flexible circuit, wherein each hollow cavity is defined between the resilient spring member and the first sidewall of the compartment casing.

In an aspect, the resilient spring member of the worn patient monitor comprises a recess adjacent to at least one conductive pad of the flexible circuit, where the recess is defined between the resilient spring member and the folded portion of the flexible circuit.

In an aspect, the battery compartment assembly of the worn patient monitor comprises one or more stiffening members coupled to the flexible circuit adjacent to each of the one or more conductive pads, wherein the recess of the resilient spring member is sized to receive the one or more stiffening members.

These and other aspects of the various embodiments will be apparent from and elucidated with reference to the embodiments described hereinafter.

### Brief Description of the Drawings

In the drawings, like reference characters generally refer to the same parts throughout the different views. Also, the drawings are not necessarily to scale, emphasis instead generally being placed upon illustrating the principles of the various embodiments.
FIG. 1 is an exploded view of a battery compartment assembly illustrated according to aspects of the present disclosure.
FIG. 2A is first perspective view a compartment casing illustrated according to aspects of the present disclosure.
FIG. 2B is second perspective view a compartment casing illustrated according to aspects of the present disclosure.
FIG. 3 is a flexible circuit illustrated according to aspects of the present disclosure.
FIG. 4 is a cross-sectional view of a battery compartment assembly illustrated according to aspects of the present disclosure.
FIG. 5A is a first perspective view of a resilient spring member illustrated according to aspects of the present disclosure.
FIG. 5B is a second perspective view of a resilient spring member illustrated according to aspects of the present disclosure.
FIG. 6 is a partial perspective view of a compartment casing illustrated according to aspects of the present disclosure.
FIG. 7A is a front plan view of a worn patient monitor illustrated according to aspects of the present disclosure.
FIG. 7B is a side plan view of a worn patient monitor illustrated according to aspects of the present disclosure.

### Detailed Description of Embodiments

According to the present disclosure, battery compartment assemblies having a flexible circuit spring component are provided. Also provided herein are patient worn monitors including such battery compartment assemblies that have features extending the life cycle thereof.

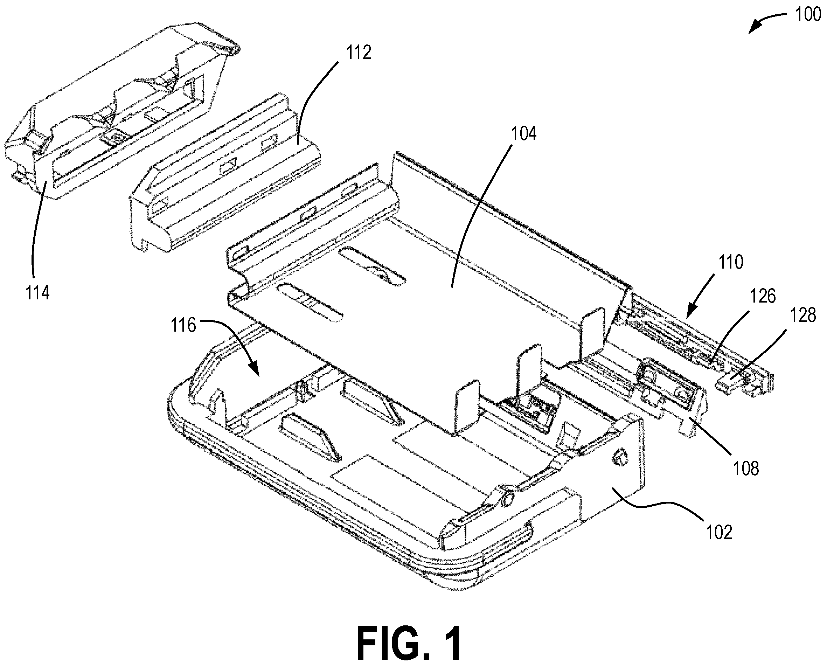

Turning to FIG. 1, an exploded view of a battery compartment assembly 100 is illustrated according to aspects of the present disclosure. According to the present disclosure, the battery compartment assembly 100 includes at least a compartment casing 102, a flexible circuit 104, and a resilient spring member 108. In further embodiments, the battery compartment assembly 100 can include a bumper member 110. In yet further embodiments, the battery compartment assembly 100 may also include a second resilient spring member 112 and/or a shroud 114.

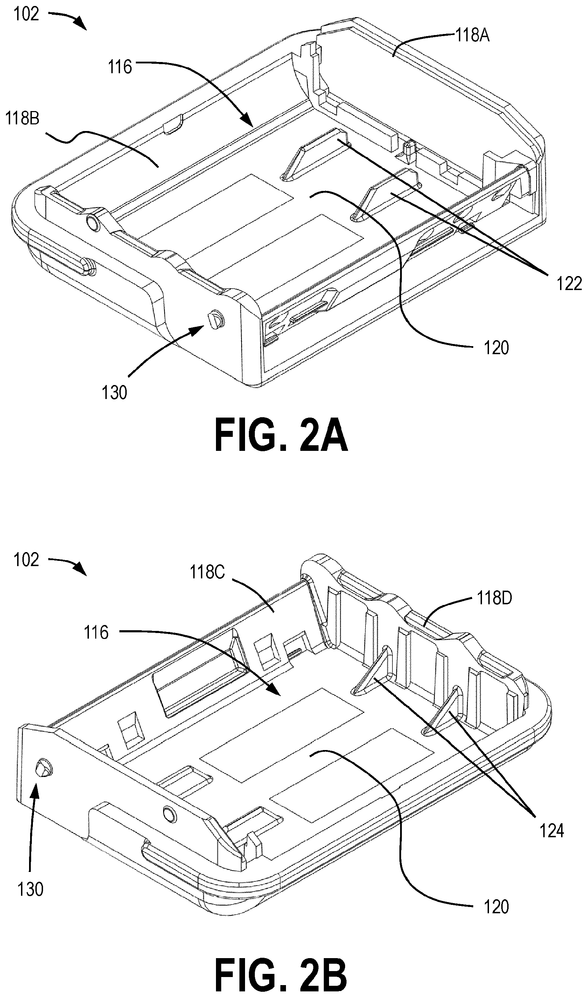

In embodiments, the compartment casing 102 of the battery compartment assembly 100 includes one or more sidewalls that define a receiving area 116 sized to receive one or more removable batteries. As shown in FIG. 2A and FIG. 2B, the battery compartment assembly 100 may be a battery door assembly 100 with a compartment casing 102 that includes sidewalls 118A, 118B, 118C, 118D and a floor 120. The sidewalls 118A, 118B, 118C, 118D and floor 120 may define the receiving area 116 such that the receiving area 116 is configured to receive one or more batteries, including but not limited to, one or more AA batteries, AAA batteries, and/or rechargeable batteries. The batteries (not shown) may preferably extend longitudinally between sidewall 118A and sidewall 118D. In some embodiments, sidewalls 118A, 118B, 118C, 118D and a floor 120 may include one or more spacers 112, 124 to space the batteries.

In embodiments, the compartment casing 102 of the battery compartment assembly 100 may be formed from a rigid material, such as a medical-grade thermoplastic polymer having high impact resistance and resistance to chemical, and a low moisture absorption. In particular embodiments, the compartment casing 102 of the battery compartment assembly 100 can comprise a medical-grade polycarbonate, polypropylene, polyethylene, and the like, and/or combinations thereof.

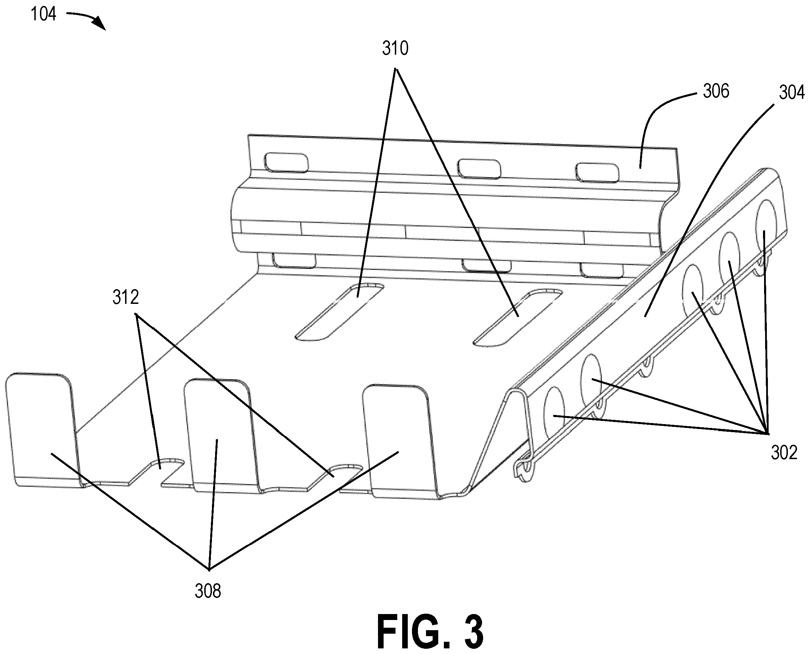

Turning to FIG. 1 and FIG. 3, a flexible circuit 104 of the battery compartment assembly 100 may extend over the compartment casing 102 and into the interior thereof. In embodiments, the flexible circuit 104 connects the batteries to an associated electronic device. For example, the flexible circuit 104 can include conductive tracings (i.e., electrical circuits) that connect the batteries and provide power to the associated electronic device through one or more conductive pads 302. In some embodiments, the flexible circuit 104 of the battery compartment assembly 100 may include at least one conductive pad 302, or may include a plurality of conductive pads 302. As shown in FIG. 3, the flexible circuit 104 of the battery compartment assembly 100 includes five conductive pads 302.

In particular embodiments, the flexible circuit 104 includes a flexible substrate with elastically conductive pads 302 defining one or more power contacts. Tracings extend through the interior and/or along a rear surface of the flexible circuit 104. In some embodiments, the flexible circuit 104 may be formed from multiple layers, including but not limited to, one or more insulating layers, one or more conductive layers, and the like. In embodiments, the one or more conductive layers can be etched to define traces and the contacts 302 for interfacing with an associated electronic device and the batteries. The conductive layers are suitably gold, copper, or the like. As described herein, the conductive traces interconnect the plurality of contacts 104 and the batteries to provide power in the form of electricity. Insulating layers are suitably placed around and, if appropriate, between the conductive layers, such that only the contacts 302 are exposed. The insulating layers are suitably formed from a polymeric material.

In further embodiments, the conductive pads 302 may be plated onto or snap into the flexible circuit 104 to form one or more power contacts. For example, the conductive pads 302 may be plated with a conducting material, such as a gold material.

An adhesive layer on or applied to the rear surface of the flexible circuit 104 may adhere the flexible circuit 104 to the floor 120 of the compartment casing 102, along the exterior of the compartment casing 102, around the top edge of the sidewalls 118A, 118B, 118C, 118D, and/or along the interior of the sidewalls 118A, 118B, 118C, 118D. In embodiments, the adhesive may be selected to provide a fluid tight seal between the flexible circuit 104 and the compartment casing 102 to prevent microbes from getting between the compartment casing 102 and the flexible circuit 104. The adhesive may be selected to be resistant to chemical disinfectants. In other embodiments, alternative and/or additional techniques such as solvent welding, thermal bonding, and the like may be used.

As mentioned above, the flexible circuit 104 of the battery compartment assembly 100 may be folded over the exterior of the compartment casing 102 and extend into the receiving area 116 of the compartment casing 102. For example, as shown in FIG. 3, the flexible circuit 104 of the battery compartment assembly 100 can include a folded portion 304 that is to be folded over at least one sidewall 118C of the compartment casing 102. In particular embodiments, each of the conductive pads 302 may be suitably disposed on a common side of the flexible circuit 104 such that the conductive pads 302 are exposed on the outside of the folded portion 304 of the flexible circuit 104.

In further embodiments, the flexible circuit 104 may further include one or more additional folded portions, such as folded portions 306, 308. The folded portions 304, 306 can be configured to contact the terminals of the one or more batteries and provide power to an associated electronic device through the tracings and conductive pads 302 of the flexible circuit 104. The flexible circuit 104 may also include one or more alignment cutouts 310, 312 that align the flexible circuit 132 with alignment projections of the compartment casing 102.

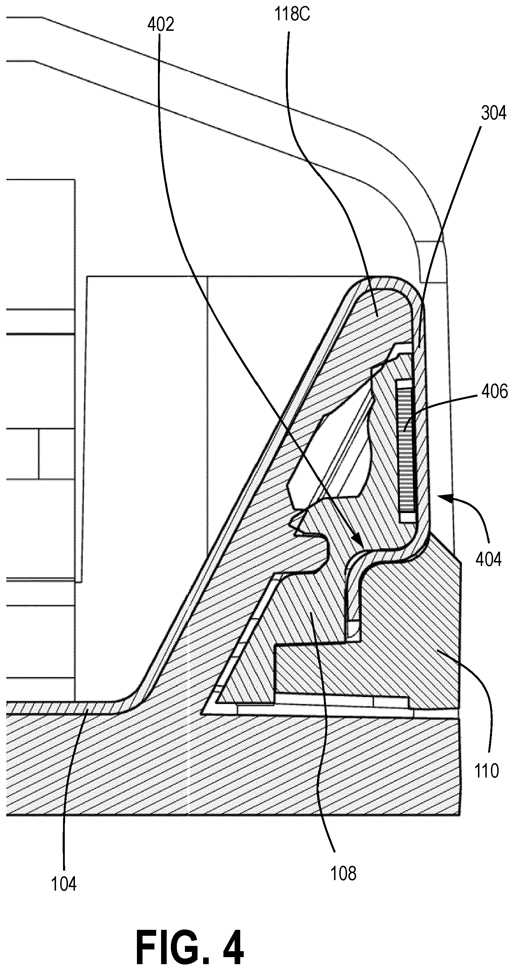

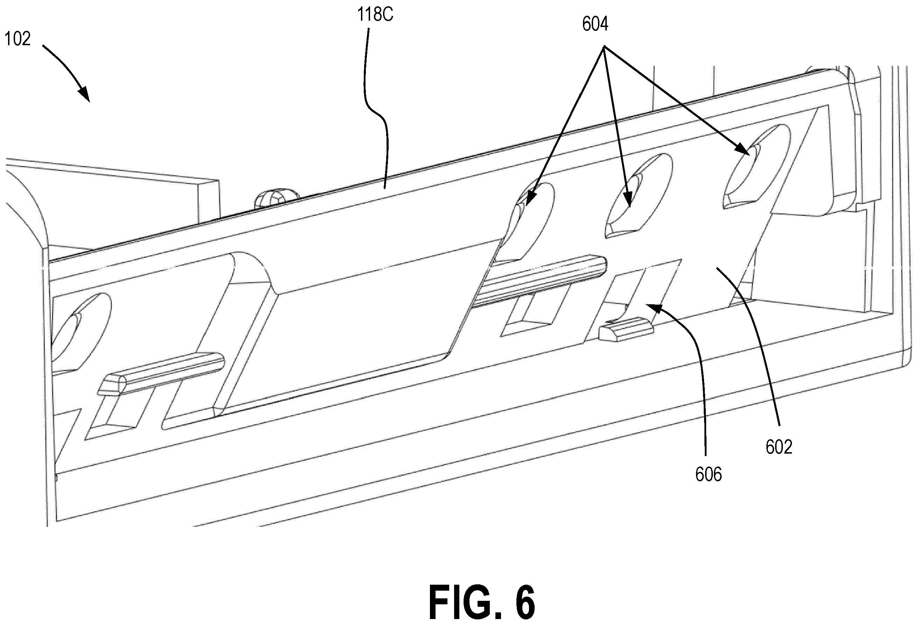

Turning to FIG. 4, the battery compartment assembly 100 also includes a resilient spring member 108 disposed between a sidewall 118C of the compartment casing 102 and an interior surface 402 of the flexible circuit 104. In embodiments, the resilient spring member 108 is formed of a flexible and/or compressible material, such as silicone, through a process such as injection molding. In some embodiments, the resilient spring member 108 may be secured between the sidewall 118C of the compartment casing 102 and the interior surface 402 of the flexible circuit 104 via a bumper member 110. For example, the bumper member 110 may include one or more fastening features 126, 128 (shown in FIG. 1) configured to join or mate with one or more complementary slots (e.g., slot 606 shown in FIG. 6) provided in the compartment casing 102 and/or the resilient spring member 108 when the bumper member 110 is pressed alongside an exterior surface 404 of the flexible circuit 104 or a portion thereof (e.g., the folded portion 304).

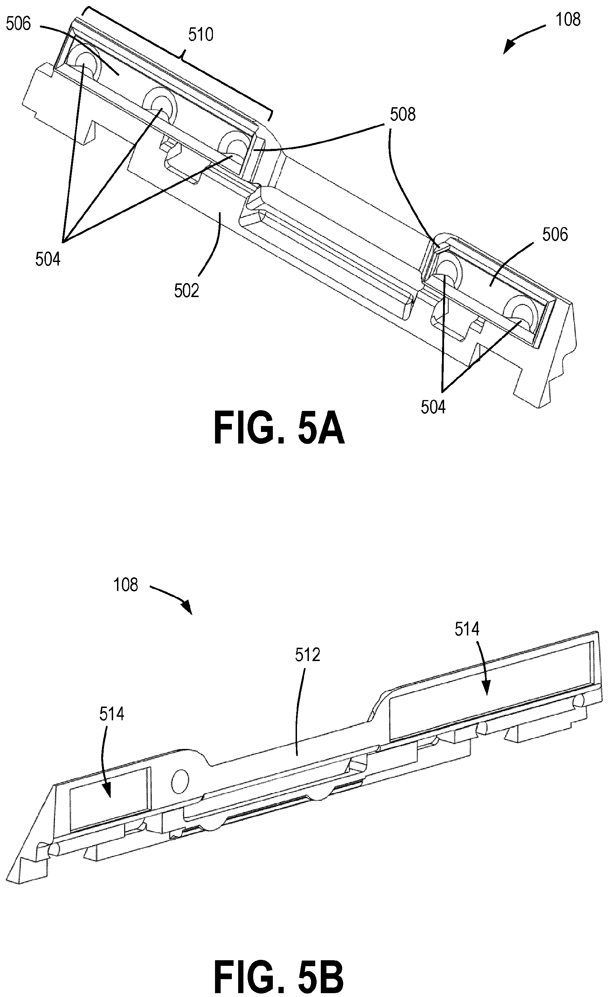

With reference to FIG. 5A, a perspective view of a resilient spring member 108 is illustrated according to further aspects of the present disclosure. In embodiments, the resilient spring member 108 includes one or more surfaces 502 having one or more hollow cavities 504 disposed therein. Between each of the hollow cavities 504, the resilient spring member 108 may include one or more solid portions 506 where there is no cavitation. In embodiments, the solid portions 506 may be flush with the surface 502 of the resilient spring member 108.

In particular embodiments, each of the one or more hollow cavities 504 of the resilient spring member 108 may include a concave surface defining the cavity. In some embodiments, each of the one or more hollow cavities 504 is defined between the resilient spring member 108 and the sidewall 118C of the compartment casing 102. In further embodiments, each of the one or more hollow cavities 504 of the resilient spring member 108 may be adjacent to a conductive pad 302 of the flexible circuit 104. For example, in specific embodiments, a flexible circuit 104 having a number of conductive pads 302 for providing power to an associated electronic device will also include a resilient spring member 108 having an equal number of hollow cavities 504 with each hollow cavity 504 corresponding to one of the conductive pads 302.

In embodiments, the first surface 502 of the resilient spring member 108 further includes a sealing bead 508 that extends outwardly from the first surface 502. The sealing bead 508 can be configured to circumscribe or otherwise create a perimeter around one or more of the hollow cavities 504 of the resilient spring member 108. For example, as shown in FIG. 5A, the resilient spring member 108 includes a first set of three hollow cavities 504 circumscribed by a first sealing bead 508, and a second set of two hollow cavities 504 circumscribed by a second sealing bead 508.

Each sealing bead 508 of the resilient spring member 108 may be configured to provide a continuous contact with an exterior surface (surface 602 shown in FIG. 6) of the sidewall 118C of the compartment casing 102 such that fluid and/or debris cannot become trapped within the air chamber 510 formed therein. That is, when assembled, the sealing bead 508, solid portions 506, and the hollow cavities 504 of the resilient spring member 108 form one or more air chambers 510 with the sidewall 118A of the compartment casing 102. In embodiments, each air chamber 510 is adjacent to at least one conductive pad 302 of the flexible circuit 104. In further embodiments, at least one of the air chamber 510 is adjacent to two or more conductive pads 302 of the flexible circuit 104.

In particular embodiments, the air chambers 510 may further include one or more hollow cavities 604 formed in an exterior surface 602 of the sidewall 118C. For example, as shown in FIG. 6, the sidewall 118C (over which the flexible circuit 104 is folded) includes a plurality of hollow cavities 604 formed on an exterior surface 602 of the sidewall 118C. Each of the follow cavities 604 may be defined by a concave surface extending into the sidewall 118C, and may be spaced apart by portions of the surface 602 not having any cavitation. In embodiments, the hollow cavities 604 of the sidewall 118C are defined between the sidewall 118C and the resilient spring member 108. In further embodiments, each hollow cavity 604 of the sidewall 118C may be adjacent to a hollow cavity 504 of the resilient spring member 108.

In still further embodiments, the battery compartment assembly 100 may further include one or more additional cavities, air chambers, and/or stiffening members configured to support the flexing of the conductive contact pads 302 when engaging with an electrical contact of the associated electronic device. For example, with reference to FIG. 5B, an exterior surface 512 of the resilient spring member 108 can include one or more recesses 514 defined between the resilient spring member 108 and a folded portion 304 of the flexible circuit 104 (such as an interior surface 402 of the folded portion 304 shown in FIG. 4).

In particular embodiments, as shown in FIG. 4, the battery compartment assembly 100 can one or more stiffening members 406 coupled to interior surface 402 of the flexible circuit 104 such that when assembled, the stiffening members 406 are disposed within the one or more recesses 514 of the resilient spring member 108. Put another way, the one or more recesses 514 of the resilient spring member 108 may be sized to receive one or more stiffening members 406 coupled to the interior surface 402 of the flexible circuit 104.

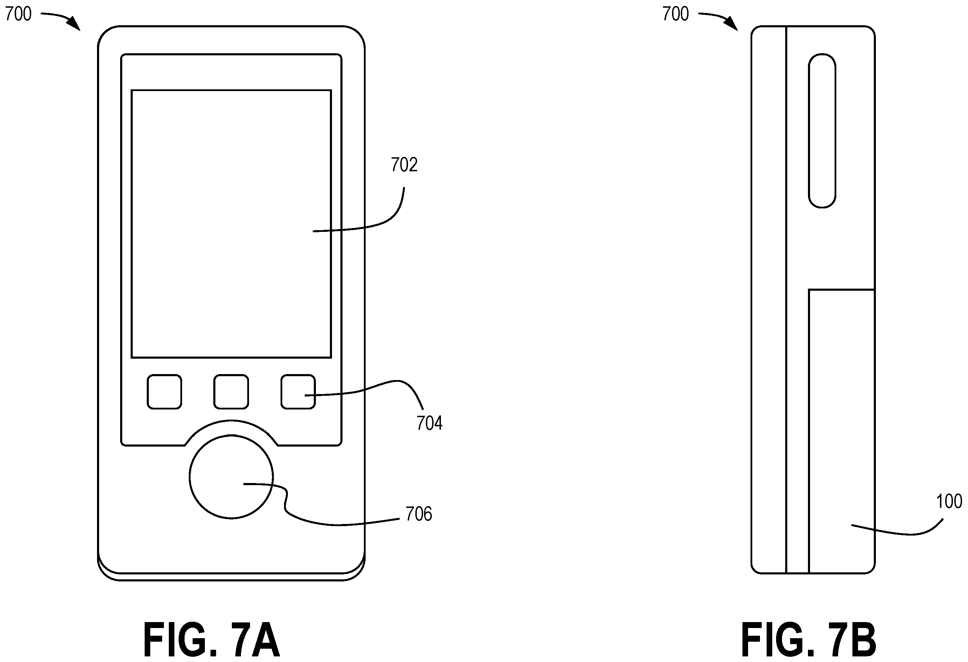

Also provided herein are battery-powered patient monitors, including but not limited to, worn patient monitors. For example, with reference to FIG. 7A and FIG. 7B, a worn patient monitor 700 is illustrated in a front plan view and side plan view, respectively, according to aspects of the present disclosure. In embodiments, the patient monitor 700 may include a battery compartment assembly 100 configured to receive one or more removeable batteries and to provide one or more power contacts (e.g., contacts 302) that supply power from the removable batteries to the patient monitor 700. In particular embodiments, the battery compartment assembly 100 includes one or more hollow cavities 504, 604, recesses 514, stiffening members 406, and/or air chambers 510 as described herein.

In further embodiments, the battery compartment assembly 100 may be hinged at one of the sidewalls 118A, 118B, 118C, 118D of the compartment casing 102 such that the battery compartment assembly 100 can be rotated relative to the rest of the patient monitor 700 about a fixed axis. For example, as shown in FIG. 2A and FIG. 2B, the exterior surfaces of the sidewalls 118A, 118D include protrusions 130 to engage the housing of the patient monitor 700 and enable the battery compartment assembly 100 to open, thereby allowing any batteries to be inserted, removed, and/or replaced.

In exemplary embodiments, the patient monitor 700 can include one or more electronic components requiring power, including but not limited to, one or more display screens 702 (e.g., a liquid crystal display (LCD), a thin film transistor-liquid crystal display (TFT-LCD), an organic light-emitting diode display (OLED), a flexible display, a three-dimensional display, a touch screen, and/or the like), one or more touch-capacitive buttons 704, one or more tactile buttons 706 (e.g., push button, rocker, slide, and/or the like), a controller or microcontroller (not shown) configured to operate the patient monitor 700 and communicate with other devices, and one or more sensors (not shown) operatively connected to the patient monitor 700, among other components.

As described herein, the patient monitors 700 of the present disclosure are configured to provide one or more conductive pins (not shown) that contact engage the one or more conductive pads 302 of the flexible circuit 104 when the battery compartment assembly 100 is engaged. These conductive pins of the patient monitors 700 cause the conductive pads 302 to flex, thereby creating wear in the flexible circuit 104, as well as the resilient spring member 108, every time that the battery compartment assembly 100 is opened and closed. According to the present disclosure, it has been found that using various combinations of air chambers 510, hollow cavities 504, 605, and/or stiffening members 406 as described herein can drastically improve the durability and expected life of the power contacts of the battery compartment assembly 100.

In one example, a comparative embodiment of a battery compartment assembly not having any air chambers 510, hollow cavities 504, 605, and/or stiffening members 406 as described herein, demonstrated a contact life of about 25 to about 50 cycles. In comparison, an inventive embodiment of the present disclosure comprising a combination of air chambers 510, hollow cavities 504, 605, and stiffening members 406 demonstrated a contact life of over 5500 cycles with no failures observed.

It should be appreciated that all combinations of the foregoing concepts and additional concepts discussed in greater detail below (provided such concepts are not mutually inconsistent) are contemplated as being part of the inventive subject matter disclosed herein. In particular, all combinations of claimed subject matter appearing at the end of this disclosure are contemplated as being part of the inventive subject matter disclosed herein. It should also be appreciated that terminology explicitly employed herein that also may appear in any disclosure incorporated by reference should be accorded a meaning most consistent with the particular concepts disclosed herein.

All definitions, as defined and used herein, should be understood to control over dictionary definitions, definitions in documents incorporated by reference, and/or ordinary meanings of the defined terms.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e. "one or the other but not both") when preceded by terms of exclusivity, such as "either," "one of," "only one of," or "exactly one of."

As used herein in the specification and in the claims, the phrase "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified.

As used herein, although the terms first, second, third, etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

Unless otherwise noted, when an element or component is said to be "connected to," "coupled to," or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" to another element or component, this encompasses only cases where the two elements or components are connected to each other without any intermediate or intervening elements or components.

In the claims, as well as in the specification above, all transitional phrases such as "comprising," "including," "carrying," "having," "containing," "involving," "holding," "composed of," and the like are to be understood to be open-ended, i.e., to mean including but not limited to. Only the transitional phrases "consisting of" and "consisting essentially of" shall be closed or semi-closed transitional phrases, respectively.

The invention is defined in the appended claims.

## Claims

1. A battery compartment assembly (100) comprising:
a compartment casing (102) having one or more sidewalls (118A, 118B, 118C, 118D) that define a receiving area (116) sized to receive one or more removable batteries;
a flexible circuit (104) disposed within the receiving area of the compartment casing and having a folded portion (304) that is folded over at least a first sidewall of the compartment casing, wherein the flexible circuit further comprises one or more conductive pads (302) disposed in the folded portion of the flexible circuit; and
a resilient spring member (108) disposed between the first sidewall of the compartment casing and a first surface (502) of the flexible circuit, the resilient spring member comprising one or more hollow cavities (504) adjacent to each of the one or more conductive pads of the flexible circuit, wherein each hollow cavity is defined between the resilient spring member and the first sidewall of the compartment casing.

2. The battery compartment assembly of claim 1, wherein the resilient spring member comprises one or more solid portions (506) between each of the one or more hollow cavities of the resilient spring member.

3. The battery compartment assembly of claim 1, wherein the resilient spring member comprises a sealing bead (508) circumscribing one or more of the hollow cavities of the resilient spring member, the sealing bead being configured to provide a continuous contact with an exterior surface (602) of the first sidewall of the compartment casing.

4. The battery compartment assembly of claim 3, wherein the sealing bead, the resilient spring member, and the first sidewall of the compartment casing forms an air chamber (510) adjacent to one or more conductive pads of the flexible circuit.

5. The battery compartment assembly of claim 1, wherein the resilient spring member comprises a recess adjacent to at least one conductive pad of the flexible circuit, the recess being defined between the resilient spring member and the folded portion of the flexible circuit.

6. The battery compartment assembly of claim 5, further comprising one or more stiffening members (406) coupled to the flexible circuit adjacent to each of the one or more conductive pads, wherein the recess of the resilient spring member is sized to receive the one or more stiffening members.

7. The battery compartment assembly of claim 1, wherein the compartment casing includes one or more hollow cavities in the first sidewall of the compartment casing, each hollow cavity in the first sidewall of the compartment casing being defined between the first sidewall and the resilient spring member, and wherein each cavity in the first sidewall of the compartment casing is adjacent to a hollow cavity of the resilient spring member.

8. The battery compartment assembly of claim 7, wherein each of the hollow cavities of the compartment casing and each of the hollow cavities of the resilient spring member have a concave surface defining the hollow cavity.

9. The battery compartment assembly of claim 1, wherein the resilient spring member is secured between the first sidewall of the compartment casing and the folded portion of the flexible circuit by a bumper member (110).

10. The battery compartment assembly of claim 9, wherein the bumper member comprises one or more latches configured to join the bumper member to the resilient spring member and the compartment casing.

11. The battery compartment assembly of claim 1, wherein the compartment casing is formed from a rigid material.

12. The battery compartment assembly of claim 1, wherein the resilient spring member is formed from at least a compressible polymer.

13. A worn patient monitor (700) comprising a battery compartment assembly (100), according to claim 1, the battery compartment assembly providing one or more power contacts (302) configured to power the worn patient monitor using one or more removable batteries, wherein the battery compartment assembly comprises:
a compartment casing (102) having one or more sidewalls (118A, 118B, 118C, 118D) that define a receiving area (116) sized to receive one or more removable batteries;
a flexible circuit (104) disposed within the receiving area of the compartment casing and having a folded portion (304) that is folded over at least a first sidewall of the compartment casing, wherein the flexible circuit further comprises one or more conductive pads (302) disposed in the folded portion of the flexible circuit; and
a resilient spring member (108) disposed between the first sidewall of the compartment casing and a first surface (502) of the flexible circuit, the resilient spring member comprising one or more hollow cavities (504) adjacent to each of the one or more conductive pads of the flexible circuit, wherein each hollow cavity is defined between the resilient spring member and the first sidewall of the compartment casing.

14. The worn patient monitor of claim 13, wherein the resilient spring member comprises a recess adjacent to at least one conductive pad of the flexible circuit, the recess being defined between the resilient spring member and the folded portion of the flexible circuit.

15. The worn patient monitor of claim 14, wherein the battery compartment assembly comprises one or more stiffening members (406) coupled to the flexible circuit adjacent to each of the one or more conductive pads, wherein the recess of the resilient spring member is sized to receive the one or more stiffening members.

## Patentansprüche

1. Batteriefachanordnung (100), umfassend:
ein Fachgehäuse (102), das eine oder mehrere Seitenwände (118A, 118B, 118C, 118D) aufweist, die einen Aufnahmebereich (116) definieren, der so dimensioniert ist, dass er eine oder mehrere entfernbare Batterien aufnimmt;
eine flexible Schaltung (104), die innerhalb des Aufnahmebereichs des Fachgehäuses angeordnet ist und einen gefalteten Abschnitt (304) aufweist, der über mindestens eine erste Seitenwand des Fachgehäuses gefaltet ist, wobei die flexible Schaltung weiter eine oder mehrere leitfähige Kontaktflächen (302) umfasst, die in dem gefalteten Abschnitt der flexiblen Schaltung angeordnet sind; und
ein elastisches Federelement (108), das zwischen der ersten Seitenwand des Fachgehäuses und einer ersten Oberfläche (502) der flexiblen Schaltung angeordnet ist, wobei das elastische Federelement einen oder mehrere Hohlräume (504) umfasst, die an jede von der einen oder den mehreren leitfähigen Kontaktflächen der flexiblen Schaltung angrenzen, wobei jeder Hohlraum zwischen dem elastischen Federelement und der ersten Seitenwand des Fachgehäuses definiert ist.

2. Batteriefachanordnung nach Anspruch 1, wobei das elastische Federelement einen oder mehrere massive Abschnitte (506) zwischen jedem von dem einen oder den mehreren Hohlräumen des elastischen Federelements umfasst.

3. Batteriefachanordnung nach Anspruch 1, wobei das elastische Federelement eine Dichtungswulst (508) umfasst, die einen oder mehrere der Hohlräume des elastischen Federelements umschließt, wobei die Dichtungswulst so konfiguriert ist, dass sie einen kontinuierlichen Kontakt mit einer Außenfläche (602) der ersten Seitenwand des Fachgehäuses bereitstellt.

4. Batteriefachanordnung nach Anspruch 3, wobei die Dichtungswulst, das elastische Federelement und die erste Seitenwand des Fachgehäuses eine Luftkammer (510) bilden, die an eine oder mehrere leitfähige Kontaktflächen der flexiblen Schaltung angrenzt.

5. Batteriefachanordnung nach Anspruch 1, wobei das elastische Federelement eine Aussparung angrenzend an mindestens eine leitfähige Kontaktfläche der flexiblen Schaltung umfasst, wobei die Aussparung zwischen dem elastischen Federelement und dem gefalteten Abschnitt der flexiblen Schaltung definiert ist.

6. Batteriefachanordnung nach Anspruch 5, weiter umfassend ein oder mehrere Versteifungselemente (406), die mit der flexiblen Schaltung angrenzend an jede von der einen oder den mehreren leitfähigen Kontaktflächen verbunden sind, wobei die Aussparung des elastischen Federelements so dimensioniert ist, dass sie das eine oder die mehreren Versteifungselemente aufnimmt.

7. Batteriefachanordnung nach Anspruch 1, wobei das Fachgehäuse einen oder mehrere Hohlräume in der ersten Seitenwand des Fachgehäuses einschließt, wobei jeder Hohlraum in der ersten Seitenwand des Fachgehäuses zwischen der ersten Seitenwand und dem elastischen Federelement definiert ist und wobei jeder Hohlraum in der ersten Seitenwand des Fachgehäuses an einen Hohlraum des elastischen Federelements angrenzt.

8. Batteriefachanordnung nach Anspruch 7, wobei jeder von den Hohlräumen des Fachgehäuses und jeder von den Hohlräumen des elastischen Federelements eine konkave Oberfläche aufweist, die den Hohlraum definiert.

9. Batteriefachanordnung nach Anspruch 1, wobei das elastische Federelement zwischen der ersten Seitenwand des Fachgehäuses und dem gefalteten Teil der flexiblen Schaltung durch ein Pufferelement (110) befestigt ist.

10. Batteriefachanordnung nach Anspruch 9, wobei das Pufferelement einen oder mehrere Riegel umfasst, die so konfiguriert sind, dass sie das Pufferelement mit dem elastischen Federelement und dem Fachgehäuse verbinden.

11. Batteriefachanordnung nach Anspruch 1, wobei das Fachgehäuse aus einem starren Material geformt ist.

12. Batteriefachanordnung nach Anspruch 1, wobei das elastische Federelement aus mindestens einem komprimierbaren Polymer geformt ist.

13. Tragbarer Patientenmonitor (700), der eine Batteriefachanordnung (100) nach Anspruch 1 umfasst, wobei die Batteriefachanordnung einen oder mehrere Leistungskontakte (302) bereitstellt, die so konfiguriert sind, dass sie den tragbaren Patientenmonitor unter Verwendung einer oder mehrerer entfernbarer Batterien speisen, wobei die Batteriefachanordnung umfasst:
ein Fachgehäuse (102), das eine oder mehrere Seitenwände (118A, 118B, 118C, 118D) aufweist, die einen Aufnahmebereich (116) definieren, der so dimensioniert ist, dass er eine oder mehrere entfernbare Batterien aufnimmt;
eine flexible Schaltung (104), die innerhalb des Aufnahmebereichs des Fachgehäuses angeordnet ist und einen gefalteten Abschnitt (304) aufweist, der über mindestens eine erste Seitenwand des Fachgehäuses gefaltet ist, wobei die flexible Schaltung weiter eine oder mehrere leitfähige Kontaktflächen (302) umfasst, die in dem gefalteten Abschnitt der flexiblen Schaltung angeordnet sind; und
ein elastisches Federelement (108), das zwischen der ersten Seitenwand des Fachgehäuses und einer ersten Oberfläche (502) der flexiblen Schaltung angeordnet ist, wobei das elastische Federelement einen oder mehrere Hohlräume (504) umfasst, die an jede von der einen oder den mehreren leitfähigen Kontaktflächen der flexiblen Schaltung angrenzen, wobei jeder Hohlraum zwischen dem elastischen Federelement und der ersten Seitenwand des Fachgehäuses definiert ist.

14. Tragbarer Patientenmonitor nach Anspruch 13, wobei das elastische Federelement eine Aussparung angrenzend an mindestens eine leitfähige Kontaktfläche der flexiblen Schaltung umfasst, wobei die Aussparung zwischen dem elastischen Federelement und dem gefalteten Abschnitt der flexiblen Schaltung definiert ist.

15. Tragbarer Patientenmonitor nach Anspruch 14, wobei die Batteriefachanordnung ein oder mehrere Versteifungselemente (406) umfasst, die mit der flexiblen Schaltung angrenzend an jede von der einen oder den mehreren leitfähigen Kontaktflächen verbunden sind, wobei die Aussparung des elastischen Federelements so dimensioniert ist, dass sie das eine oder die mehreren Versteifungselemente aufnimmt.

## Revendications

1. Ensemble de compartiment de batterie (100) comprenant :
un boîtier de compartiment (102) présentant une ou plusieurs parois latérales (118A, 118B, 118C, 118D) qui définissent une zone de réception (116) dimensionnée pour recevoir une ou plusieurs batteries amovibles ;
un circuit flexible (104) disposé au sein de la zone de réception du boîtier de compartiment et présentant une portion pliée (304) qui est pliée par-dessus au moins une première paroi latérale du boîtier de compartiment, dans lequel le circuit flexible comprend en outre une ou plusieurs pastilles conductrices (302) disposées dans la portion pliée du circuit flexible ; et
un organe de ressort élastique (108) disposé entre la première paroi latérale du boîtier de compartiment et une première surface (502) du circuit flexible, l'organe de ressort élastique comprenant une ou plusieurs cavités creuses (504) adjacentes à chacune de l'une ou des plusieurs pastilles conductrices du circuit flexible, dans lequel chaque cavité creuse est définie entre l'organe de ressort élastique et la première paroi latérale du boîtier de compartiment.

2. Ensemble de compartiment de batterie selon la revendication 1, dans lequel l'organe de ressort élastique comprend une ou plusieurs portions solides (506) entre chacune de l'une ou des plusieurs cavités creuses de l'organe de ressort élastique.

3. Ensemble de compartiment de batterie selon la revendication 1, dans lequel l'organe de ressort élastique comprend un joint d'étanchéité (508) circonscrivant une ou plusieurs des cavités creuses de l'organe de ressort élastique, le joint d'étanchéité étant configuré pour fournir un contact continu avec une surface extérieure (602) de la première paroi latérale du boîtier de compartiment.

4. Ensemble de compartiment de batterie selon la revendication 3, dans lequel le joint d'étanchéité, l'organe de ressort élastique et la première paroi latérale du boîtier de compartiment forment une chambre à air (510) adjacente à une ou plusieurs pastilles conductrices du circuit flexible.

5. Ensemble de compartiment de batterie selon la revendication 1, dans lequel l'organe de ressort élastique comprend un évidement adjacent à au moins une pastille conductrice du circuit flexible, l'évidement étant défini entre l'organe de ressort élastique et la portion pliée du circuit flexible.

6. Ensemble de compartiment de batterie selon la revendication 5, comprenant en outre un ou plusieurs organes de raidissement (406) couplés au circuit flexible adjacent à chacune de l'une ou des plusieurs pastilles conductrices, dans lequel l'évidement de l'organe de ressort élastique est dimensionné pour recevoir l'un ou les plusieurs organes de raidissement.

7. Ensemble de compartiment de batterie selon la revendication 1, dans lequel le boîtier de compartiment inclut une ou plusieurs cavités creuses dans la première paroi latérale du boîtier de compartiment, chaque cavité creuse dans la première paroi latérale du boîtier de compartiment étant définie entre la première paroi latérale et l'organe de ressort élastique, et dans lequel chaque cavité dans la première paroi latérale du boîtier de compartiment est adjacente à une cavité creuse de l'organe de ressort élastique.

8. Ensemble de compartiment de batterie selon la revendication 7, dans lequel chacune des cavités creuses du boîtier de compartiment et chacune des cavités creuses de l'organe de ressort élastique présentent une surface concave définissant la cavité creuse.

9. Ensemble de compartiment de batterie selon la revendication 1, dans lequel l'organe de ressort élastique est fixé entre la première paroi latérale du boîtier de compartiment et la portion pliée du circuit flexible par un organe de butée (110).

10. Ensemble de compartiment de batterie selon la revendication 9, dans lequel l'organe de butée comprend un ou plusieurs loquets configurés pour joindre l'organe de butée à l'organe de ressort élastique et au boîtier de compartiment.

11. Ensemble de compartiment de batterie selon la revendication 1, dans lequel le boîtier de compartiment est formé à partir d'un matériau rigide.

12. Ensemble de compartiment de batterie selon la revendication 1, dans lequel l'organe de ressort élastique est formé à partir d'au moins un polymère compressible.

13. Moniteur de patient porté (700) comprenant un ensemble de compartiment à batterie (100) selon la revendication 1, l'ensemble de compartiment à batterie fournissant un ou plusieurs contacts d'alimentation (302) configurés pour alimenter le moniteur de patient porté en utilisant une ou plusieurs batteries amovibles, dans lequel l'ensemble de compartiment à batterie comprend :
un boîtier de compartiment (102) présentant une ou plusieurs parois latérales (118A, 118B, 118C, 118D) qui définissent une zone de réception (116) dimensionnée pour recevoir une ou plusieurs batteries amovibles ;
un circuit flexible (104) disposé au sein de la zone de réception du boîtier de compartiment et présentant une portion pliée (304) qui est pliée par-dessus au moins une première paroi latérale du boîtier de compartiment, dans lequel le circuit flexible comprend en outre une ou plusieurs pastilles conductrices (302) disposées dans la portion pliée du circuit flexible ; et
un organe de ressort élastique (108) disposé entre la première paroi latérale du boîtier de compartiment et une première surface (502) du circuit flexible, l'organe de ressort élastique comprenant une ou plusieurs cavités creuses (504) adjacentes à chacune de l'une ou des plusieurs pastilles conductrices du circuit flexible, dans lequel chaque cavité creuse est définie entre l'organe de ressort élastique et la première paroi latérale du boîtier de compartiment.

14. Moniteur de patient porté selon la revendication 13, dans lequel l'organe de ressort élastique comprend un évidement adjacent à au moins une pastille conductrice du circuit flexible, l'évidement étant défini entre l'organe de ressort élastique et la portion pliée du circuit flexible.

15. Moniteur de patient porté selon la revendication 14, dans lequel l'ensemble de compartiment à batterie comprend un ou plusieurs organes de raidissement (406) couplés au circuit flexible adjacent à chacune de l'une ou des plusieurs pastilles conductrices, dans lequel l'évidement de l'organe de ressort élastique est dimensionné pour recevoir l'un ou les plusieurs organes de raidissement.
